# EUROPEAN PATENT APPLICATION

(11) **EP 4 328 028 A1**
(43) Date of publication of application: **28.02.2024**
(21) Application number: 22191755.2
(22) Date of filing: 23.08.2022
(51) Int. Cl.: B41F 15/08, B41F 15/36, H05K 3/00, H05K 3/40

(54) **FILLING HOLES OF A COMPONENT CARRIER STRUCTURE WITH CONTROLLABLE AND ALIGNABLE MOVABLE MEDIUM APPLICATOR**

(71) Applicant: AT & S Austria Technologie & Systemtechnik Aktiengesellschaft, 8700 Leoben-Hinterberg (AT)
(72) Inventor: Csarnai, Viktor, 8700 Leoben (AT); Nickkholgh, Amin, 13947-43444 Tehran (IR)
(74) Representative: Dilg, Haeusler, Schindelmann Patentanwaltsgesellschaft mbH

(57) **Abstract**

An apparatus (100) for filling holes (102) of a component carrier structure (104) with a filling medium (106), wherein the apparatus (100) comprises a medium applicator (108) for applying the filling medium (106) into the holes (102) of the component carrier structure (104), said medium applicator (108) being configured to move above a main surface of the component carrier structure (104), and a control unit (114) for controlling the movement of the medium applicator (108) to align with the holes (102) to apply the filling medium (106) into the holes (102).

## Description

### Field of the Invention

The invention relates to an apparatus for and a method of filling holes of a component carrier structure with a filling medium.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

During manufacturing component carriers, a huge number of holes may have to be filled with a filling medium, such as a dielectric or a metal. Traditionally, a squeegee may move over a component carrier structure with holes and may press filling medium in a quite uncontrolled way into the holes. Conventional approaches of filling holes in a component carrier structure may lack precision and may lead to artefacts and even damage at the component carrier structure.

### Summary of the Invention

There may be a need to fill holes in a component carrier structure in a failure robust way and with high precision.

According to an exemplary embodiment of the invention, an apparatus for filling holes of a component carrier structure with a filling medium is provided, wherein the apparatus comprises a medium applicator for applying the filling medium into the holes of the component carrier structure, said medium applicator being configured to move above a main surface of the component carrier structure, and a control unit for controlling the movement of the medium applicator to align with the holes to apply the filling medium into the holes.

According to another exemplary embodiment of the invention, a method of filling holes of a component carrier structure with a filling medium is provided, wherein the method comprises applying the filling medium into the holes of the component carrier structure by a medium applicator moving above a main surface of the component carrier structure, and controlling the movement of the medium applicator to align with the holes to apply the filling medium into the holes.

In the context of the present application, the term "component carrier" may particularly denote any support structure which is capable of accommodating, directly or indirectly, one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "component carrier structure" may particularly denote a physical structure comprising one or a plurality of component carriers, or preforms thereof. For example, a component carrier structure may be a component carrier itself. It is also possible that a component carrier structure comprises a plurality of component carriers, for instance an array of component carriers or a panel comprising component carriers. Furthermore, it is also possible that a component carrier structure is a structure obtained during manufacturing component carriers, for example a panel or an array comprising a plurality of preforms of component carriers which may still be integrally connected.

In the context of the present application, the term "hole of component carrier structure" may particularly denote an opening in the component carrier structure. Such a hole may be a through hole extending through the entire component carrier structure, may be a blind hole extending into the component carrier structure but having a closed bottom, or may be a groove, cavity (for instance for embedding a component) or recess of any shape. During executing a method of filling holes of a component carrier structure with a filling medium according to an exemplary embodiment, it may be possible that at least 100 holes, in particular at least 1000 holes, more particularly at least 10,000 holes, of the component carrier structure are filled partially or entirely with filling medium. It is also possible that a panel-type component carrier structure comprises several 100,000 holes to be filled with filling medium. In such a scenario, a huge plurality of holes shall be filled in a quick, reliable and accurate way with filling medium.

In the context of the present application, the term "filling holes" may particularly denote a process of inserting a filling medium into at least part of the respective hole. For instance, only a bottom portion or only a circumferential portion of a hole may have to be filled with a filling medium. It may also be possible that the entire hole shall be filled with a filling medium. It is also possible that not only the entire hole, but also a portion protruding beyond the hole shall be filled with a filling medium. Such a filling medium may be electrically conductive (for instance metallic paste), magnetic (for example magnetic paste) and/or dielectric (for instance electrically insulating ink). Filling medium may also be denoted as plugin material.

In the context of the present application, the term "medium applicator" may particularly denote a movable device configured for applying a filling medium into a respective hole, in particular in a metered or dosed way. For instance, a medium applicator may comprise a printer or printhead configured for applying the filling medium into the respective hole by printing, for instance injection printing. However, the medium applicator may also be a dispenser or the like.

In the context of the present application, the term "control unit" may particularly denote an entity configured for controlling operation of the apparatus for filling holes of a component carrier structure, or part thereof. For instance, such a control unit may comprise a processor, a plurality of processors, or part of a processor comprising instructions which can be executed for carrying out a medium filling task. For instance, the control unit may execute the medium filling task by carrying out a software program. In particular, the control unit may be configured for aligning the medium applicator with individual holes to thereby carry out the media filling task in a spatially controlled way.

In the context of the present application, the term "movement of a medium applicator to align with holes to apply filling medium into the holes" may particularly denote a controlled motion of the medium applicator so as to be placed specifically in alignment with one or more holes prior to applying filling medium selectively into the aligned holes. Hence, an alignment process of spatially aligning the medium applicator with respect to one or more holes of the component carrier structure may be executed prior to an actual hole filling process of filling the aligned one or more holes with a filling medium.

In particular, the component carrier structure may comprise two opposing main surfaces. The main surfaces may form the two largest surface areas of the component carrier structure. The main surfaces are connected by circumferential side walls. The thickness of a component carrier structure is defined by the distance between the two opposing main surfaces. The main surfaces may comprise functional sections, such as conductive traces or conductive interconnections with further elements. Said definition of the term main surface may apply, mutatis mutandis, also to other structures described herein, such as the below mentioned perforated screen.

According to an exemplary embodiment of the invention, holes of a component carrier structure may be at least partially filled with a filling medium in a controlled manner. For this purpose, a corresponding apparatus may be equipped with a medium applicator for applying the filling medium into the holes. Advantageously, said medium applicator may be controlled to move above a main surface of the component carrier structure for ensuring proper alignment between medium applicator and a defined subgroup of holes to be presently filled with filling medium. Such a controlled hole filling process may ensure controlled, quick and accurate filling of holes in the component carrier structure and may therefore lead to readily manufactured component carriers with high functional reliability. By ensuring spatial alignment between medium applicator and a separate group of holes to be presently filled with filling medium prior to starting the filling process, it may become possible to fill holes in a component carrier structure in a failure robust way and with high precision.

### Detailed Description of Exemplary Embodiments

In the following, further exemplary embodiments of the apparatus and the method will be explained.

In an embodiment, the apparatus comprises a perforated screen, at least partially covering (in particular in direct physical contact with the top main surface of the component carrier structure) the component carrier structure. Said perforated screen may be configured to allow the passage of the filling medium through the perforation toward the holes of the component carrier structure. By providing a perforated screen with holes to be aligned with holes of the component carrier structure to be filled with filling medium, undesired coverage of a main surface of the component carrier structure apart from the holes with filling medium may be reliably prevented. After the hole filling process, the perforated screen may be removed from the component carrier structure, which remains with properly filled holes.

In an embodiment, the apparatus comprising a detaching tool for detaching the screen from the component carrier structure. Moreover, the control unit may be configured for controlling the detaching tool to detach, preferably by pivoting, the screen away from the component carrier structure, in particular after the filling of the holes. Correspondingly, a method according to an exemplary embodiment of the invention may comprise covering the component carrier structure with a perforated screen, applying the filling medium by the medium applicator through the perforated screen into the holes of the component carrier structure, and detaching the screen from the component carrier structure by controlling a detaching tool to move (preferably to pivot) the screen away from the component carrier structure. During hole filling of the component carrier structure, the perforated screen may fulfill a control function and may promote accurate filling selectively of the holes of the component carrier structure without excessive deposition of residues of filling medium apart from the holes on the component carrier structure. However, the perforated screen, which may also be covered with excessive filling medium, is advantageously removed from the component carrier structure after the hole filling process. Depending on the used filling medium, the latter may stick or adhere more or less between component carrier structure and perforated screen. The present inventors have surprisingly found that, by pivoting the perforated screen away from the component carrier structure, the screen may be detached in a reliably and controlled way without undesired impact on the component carrier structure. This even holds in a scenario in which the filling medium is not yet fully cured or hardened after the filling process.

In an embodiment, the control unit is configured for controlling a first movable part of the detaching tool to move on and along the screen and for controlling a second movable part of the detaching tool to pivot a connected portion of the screen up to the first movable part away from the component carrier structure. Correspondingly, the method may comprise controlling a first movable part of the detaching tool to move along the screen, and controlling a second movable part of the detaching tool to pivot a portion of the screen up to the first movable part away from the component carrier structure. In order to reliably detach the perforated screen from the component carrier structure after a hole filling process, it has turned out to be of utmost advantage to provide a detaching tool with two movable parts cooperating with the perforated screen during the detachment process. While the first part moves preferably horizontally along a main surface of the perforated screen opposing another main surface facing the component carrier structure, the second movable part moves along another direction (preferably vertically) while being connected to an end section of the perforated screen. This may cause pivoting and tensioning of a portion of the perforated screen between first movable part and second movable part which may simplify detachment of the screen from the component carrier structure. At the position of the first movable part, the preferably bendable or flexible screen may experience angling. Controlled by the first movable part which may press a portion of the screen downwardly onto the component carrier structure, the portion of the perforated screen being detached from the component carrier structure may be extended successively. This has turned out as a highly successful strategy for preventing damaging or inappropriate detaching of the screen from the component carrier structure and for avoiding any undesired impact on the filling medium in the holes of the component carrier structure.

In an embodiment, it may be possible to move the first movable part parallel to an adjacent main surface of the screen with an offset between first movable part and perforated screen in vertical direction. By maintaining the bottom surface of the first movable part above the perforated screen, it may be possible to apply an extra detaching force (in particular of at least 10 N).

In an embodiment, the first movable part may be integrated in a print head of the medium applicator, i.e. may be integrally formed with such a print head. In other words, the print head with its first movable part (such as a roller) may move along the perforated screen for lifting the perforated screen from the component carrier structure. By taking this measure, the number of movable parts may be reduced which may simplify construction of the apparatus. Alternatively, the first movable part may be provided separately from the print head.

As mentioned, detaching of the perforated screen from the component carrier structure with filled holes may be accomplished preferably by pivoting the perforated screen with respect to the stationary component carrier structure. However, it may also be possible that the first movable part is placed in front of the holes, and the second movable part is firstly raised to detach the perforated screen up to the first movable part. Then, the perforated screen may be pivoted by the first movable part during its linear movement above to the holes.

In an embodiment, the first movable part comprises a roller for rolling along the screen. The first movable part may comprise at least one rotatable roller to be moved along a main surface of the perforated screen in a low friction way. The at least one movable roller may be connected with a support body by which motion of the first movable part may be controlled. As an alternative to the provision of a movable roller, the first movable part may comprise a blade for sliding along the screen. Advantageously, the blade may comprise a low friction material (for instance may be made of polytetrafluoroethylene) for preventing undesired adhesion of the first movable part on the perforated screen.

In an embodiment, the second movable part comprises a supporting structure, in particular a frame structure, supporting the screen. In particular, the second movable part may be connected to an exterior portion of the perforated screen. The second movable part may be connected to an entire perimeter of the perforated screen, or only along part thereof.

In an embodiment, the control unit is configured to move the supporting structure to thereby pivot said portion of the screen away from the component carrier structure. In particular, a vertical motion of the supporting structure may be combined and synchronized with a horizontal motion of the first movable part to thereby achieve a reliable detaching of the perforated screen from the component carrier structure with its filled holes without causing damage. For example, a plane of the support structure may be not coplanar with the component carrier structure (but in contrast to this may be tilted with respect to the component carrier structure) during the process of detaching caused by the prescribed moving.

In an embodiment, the control unit is configured for controlling the first movable part to move along the screen along an entire length extension of the component carrier structure. In a side view, the first movable part may move, in length direction, from one end section to the opposing other end section of the component carrier structure. This may ensure that the entire perforated screen is reliably detached from the component carrier after completing the hole filling process.

In an embodiment, the first movable part extends along an entire width of the component carrier structure. This may make it possible to use only a single first movable part for the entire component carrier structure. In a plan view, the first movable part may extend, in width direction, from one end section of the component carrier structure to the opposing other end section of the component carrier structure. While the first movable part may extend along the whole component carrier structure in width direction of said end sections, the first movable part may be controllable by the control unit to move along an entire length of the perforated screen. To put it shortly, the first movable part may cover the entire area of the component carrier structure or even of the perforated screen while moving from a first end position to a second end position.

In another embodiment, the first movable part is not moved over at least of a portion of the component carrier.

As an alternative to a single first movable part extending along an entire width of the component carrier structure, it may also be possible to provide a plurality of first movable parts, for instance a plurality of rollers each covering a portion of the width of the component carrier structure.

In an embodiment, the control unit is configured for controlling the first movable part to move along the screen and for controlling the second movable part to pivot the portion of the screen at least partially simultaneously. In particular, the control unit may be configured for synchronizing the motion of the first movable part and the motion of the second movable part for coordinating their motion during a screen detaching process.

In an embodiment, the medium applicator comprises at least one print head for printing the filling medium in the holes of the component carrier structure. Correspondingly, the method may comprise moving at least one print head of the medium applicator in alignment with at least one respective hole of the component carrier structure for printing the filling medium selectively in the aligned at least one hole. In particular, the medium applicator may be configured for applying the filling medium to the holes of the component carrier structure by a controlled injection printing process. Injection printing may denote a process of printing filling medium into holes of the component carrier structure by pushing a defined amount of the filling medium into the holes of the component carrier structure, in particular via through holes of the perforated screen. The medium applicator may push the pre-defined amount of material by activating a volume controlled dosing. Injection printing may occur directly into the holes or cavities through the screen or stencil. For this purpose, one print head or a plurality of print heads may be used. When a plurality of print heads are used, they can be operated separately from each other for executing injection printing tasks simultaneously. For instance, four print heads may be provided, one for each quarter panel of a panel-type component carrier structure.

In an embodiment, the medium applicator may comprise a heat exchange unit, in particular a heater, to adapt the temperature of the filling medium. In a preferred embodiment, the temperature of the medium applicator is set accordingly in order to adjust physical properties of the filling medium, e.g. viscosity, to ensure a failure free hole filling process.

For example, a respective print head may comprise a plurality of filling medium injectors. Via each filling medium injector, an assigned hole of the component carrier structure may be filled with filling medium which can be injected through said filling medium injector. Through multiple filling medium injectors of a respective print head, filling medium may be injected into a plurality of assigned holes of the component carrier structure simultaneously.

During the process of filling holes of the component carrier with filling medium from the medium applicator, also through holes of the perforated screen may be filled with filling medium, partially or entirely. In particular, the holes of the perforated screen may be filled entirely and the holes of the component carrier may be filled at least partially, preferably fully, with filling medium.

In an embodiment, the at least one print head is configured for moving along the component carrier structure for printing the filling medium in the holes of the component carrier structure. In particular, each respective print head (for example comprising one or a plurality of filling medium injectors) may be moved under control of the control unit up to a target position at which the filling medium injector(s) is or are in alignment with corresponding holes of the perforated screen and of the component carrier structure for simultaneously filling with filling medium.

In an embodiment, the medium applicator comprises a plurality of print heads each for printing the filling medium in the holes of an assigned portion, in particular a quarter panel, of the component carrier structure. For instance, different print heads may serve different portions of the component carrier and assigned portions of the perforated screen. Parallelizing the printing process in such a way may render the apparatus appropriate for high throughput applications. Providing a plurality of print heads and coordinating their function in terms of hole filling may allow to achieve a filling performance on an industrial scale.

In an embodiment, the filling medium comprises a dielectric ink, a metallic paste and/or a magnetic paste. For example, a dielectric ink may be filled in holes of a component carrier structure for preventing voids in an interior of component carriers. Dielectric ink filled holes may define regions in which no electricity shall be conducted. However, it may also be possible to fill holes of a component carrier structure with metallic paste for instance for preparing a solder or sinter process (for instance solder paste or sinter paste) or for creating desired electric circuits (for instance on the basis of copper paste or ink) in accordance with a design file of the component carriers to be manufactured. Furthermore, magnetic paste (for instance a ferrite paste) may be filled in holes of a component carrier structure, for example for electromagnetic shielding purposes or for implementing magnetic functionality (such as a coil with magnetic core filling) in component carriers.

In an embodiment, the medium applicator comprises a first applicator unit for applying a first filling medium into a first part of the holes of the component carrier structure and comprises a second applicator unit for applying another (in particular a different) second filling medium into a second part of the holes of the component carrier structure. For example, the first applicator unit and the second applicator unit may be different print heads. Advantageously, the first applicator unit and the second applicator unit may supply different filling media into different holes of the component carrier structure. For example, the first medium applicator may supply dielectric ink into a first group of holes, whereas the second medium applicator may apply a magnetic paste into a second group of holes. Using different print heads for different filling media, the hole filling process may be significantly accelerated and may be rendered more flexible.

In an embodiment, the medium applicator is configured for controlling an amount of filling medium provided for filling a respective hole based on a predefined design of the component carrier structure. For example, the design of component carriers (for instance printed circuit boards) to be manufactured may be stored in a design file including a plurality of parameters for a manufacturing process. Said design file may also comprise information about positions of holes of the component carriers and information concerning a filling of said holes (for instance a filling degree, i.e. partially or entirely, a filling medium, for instance dielectric ink or magnetic paste). The medium applicator and/or the control unit may access information indicative of said predefined design (for instance to the above mentioned design file) and may execute the hole filling process accordingly.

In an embodiment, the medium applicator is configured for a volume-based control of an amount of filling medium provided for filling a respective hole. Such a volume-regulated supply of filling medium to the individual holes of the component carrier structure may reliably ensure that a correct volume of filling medium for filling the respective hole in accordance with design rules for manufacturing component carriers may be provided. Advantageously, volume-regulated filling may be executed independently of a viscosity of the filling medium and may therefore be highly accurate. Hence, both excessive hole filling as well as inadequate hole filling may be reliably prevented. This may ensure a high yield of the manufacturing process and may promote a high reliability of the manufactured component carriers. A volume of filling medium to be inserted into each individual hole may be defined by a volume-regulated supply of filling medium in accordance with information indicative of a hollow volume (in particular determined by depth and diameter of the respective hole) in a design file specifying component carriers to be manufactured.

In an embodiment, the medium applicator is configured to fill a plurality of the holes of the component carrier structure simultaneously. This may lead to a high speed of the hole filling process and may thereby enhance the manufacturing efficiency.

In an embodiment, the apparatus comprises a vacuum chamber in which at least the medium applicator and the detaching tool are at least partially arranged. Descriptively speaking, the filling of the holes of the component carrier structure with filling medium may be carried out via the component carrier structure being at a negative pressure, for instance at an absolute pressure value below 500 mbar, in particular below 100 mbar, and more particularly below 10 mbar. By taking this measure, the impact of an atmosphere on the hole filling characteristics may be strongly suppressed, thereby rendering the hole filling process more accurate and reproducible. In particular, air inside of the holes to be filled with filling medium may be prevented or at least reduced.

In an embodiment, a stack of the component carrier structure or of the component carrier comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier structure or component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, a component carrier obtained from the component carrier structure is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metaloxide-semiconductor field-effect transistor (MOSFET), complementary metaloxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier obtained from the component carrier structure is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.

Figure 1 to Figure 6 illustrate different views of an apparatus during execution of a method of filling holes of a component carrier structure with a filling medium according to an exemplary embodiment of the invention.

Figure 7 to Figure 9 illustrate different views of an apparatus during execution of a method of filling holes of a component carrier structure with a filling medium according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, holes (such as vias and/or cavities) of a component carrier structure (such as a panel for manufacturing printed circuit boards) may be filled partially or entirely with a filling medium (such as a dielectric ink or a magnetic paste). Advantageously, a medium applicator (such as an injection printer) may be provided for applying the filling medium into the holes by moving in a controlled manner above a main surface of the component carrier structure so as to be spatially aligned with the holes to be subsequently filled with filling medium. When properly aligned as a result of an alignment process, the filling medium may be applied into the holes of the component carrier structure by the medium applicator controlled by a control unit. By a controlled motion of a medium applicator in alignment with holes of the component carrier structure to be filled with filling medium and by a subsequent controlled supply of filling medium on a supply volume-per-hole-basis, a very accurate and nevertheless fast hole filling process may be executed. Such a filling process may lead to a uniform distribution of printed filling medium (such as ink) without grinding related issues. Furthermore, copper thickness variation may be very small with such a filling architecture. According to exemplary embodiments, in particular IC substratetype component carriers may be manufactured with high quality and capability and a high level of automation.

By a preferred embodiment, an apparatus enabling an automated selective injection plugin may be provided. In particular, a high density vacuum screen printing hole plugging machine may be provided that may include a plurality of (in particular four) groups of plug hole fillers which can plug holes for different component carriers at the same time. Advantageously, such an injection apparatus may define the exact filling volume of holes (such as vias or cavities) independently of the viscosity by providing a volume-based filling control. A corresponding apparatus may also be provided with a detaching tool for smoothly detaching a perforated screen from a component carrier structure. Advantageously, such a detaching tool may reliably prevent artefacts at the component carrier structure, such as deformations caused by pull-off forces.

According to exemplary embodiments, a selective injection method for a plugin process may be provided in which a medium applicator inserts a filling medium into properly aligned holes of a component carrier structure, such as a panel. For example, such a medium applicator may comprise a plurality of application heads (for example four) to increase throughput. Advantageously, hole filling may be accomplished in accordance with volume-based printing, and thus independently of viscosity of the filling medium. Consequently, viscosity of the filling medium will not impact cycle time. To put it shortly, a volume of the filling medium used for filling a respective hole may be defined and injected or plugged in said hole. As a result, a correct amount of filling volume is metered into each individual hole to be filled. According to exemplary embodiments, global panel planarity is not a requirement for such a printing method, so that even component carrier structures with some amount of warpage can be processed and subjected to hole filling in an accurate way. As a consequence, the same filling rate may be guaranteed for each and every unit (for instance PCB) of a component carrier structure (such as a panel). Advantageously, this may make uniform plugins possible. Undesired phenomena such as copper thickness variation due to non-uniform grinding may be strongly suppressed or even eliminated according to exemplary embodiments of the invention. In contrast to conventional approaches, operator judgment concerning a quality of a filling result can be advantageously omitted. This may render the manufacturing process even more efficient. With the hole filling process according to exemplary embodiments of the invention, also holes with a high aspect ratio (i.e. ratio between depth and diameter) may be reliably filled with filling medium. According to exemplary embodiments, high density integration (HDI) printed circuit boards (PCBs) or integrated circuit (IC) substrate core layers may be manufactured. Component carriers manufactured according to exemplary embodiments of the invention may be produced with high yield and high stability. Process efficiency may be enhanced by an improved uniformity of a plugin process. Efficiency enhancement may be achieved due to less process variation and a more stable product quality, which may lead also to a high yield. Furthermore, a high productivity may be achieved by shortening the filling cycle time by providing a plurality of applicator units (for instance print heads) of a medium applicator (for instance a medium applicator having (for example four) applicator heads working at the same time in different regions of the component carrier structure).

According to an exemplary embodiment of the invention, an apparatus for filling holes of a component carrier structure with a filling medium provides an advantageous injecting system for plugging different kinds of filling media in paste format with different values of viscosity. Preferably, such an apparatus may also be equipped with a detaching tool for smoothly detaching a perforated screen from a component carrier structure with filled holes without creating artefacts, such as dent formation caused by pull off forces. Consequently, an apparatus according to exemplary embodiments of the invention allows a selective injection plugin of individual holes of a component carrier structure. Thus, it may be possible to plug or fill holes (for instance mechanically-drilled or laser-drilled holes and also cavities for embedding technology) with a filling medium.

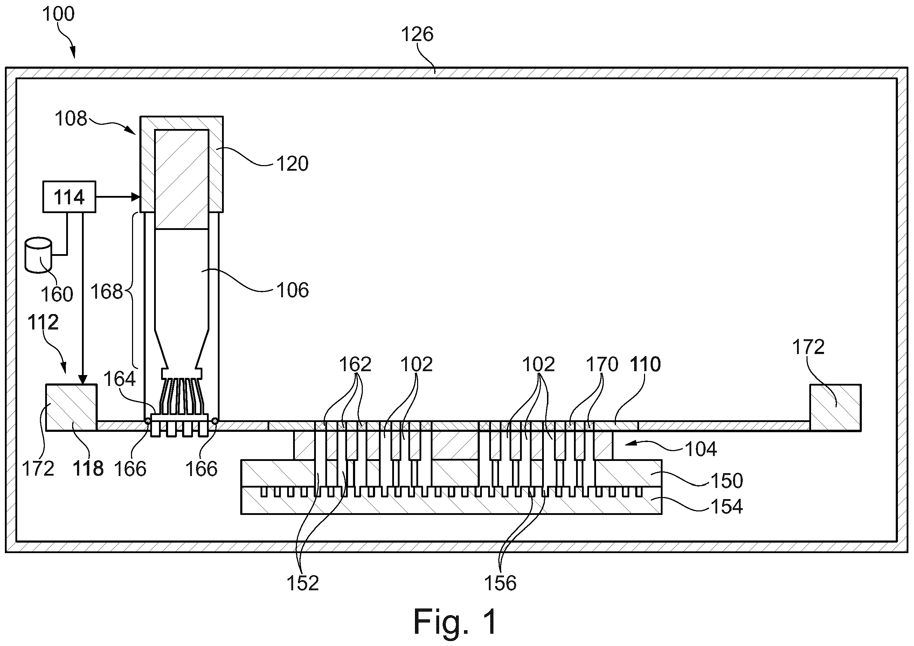

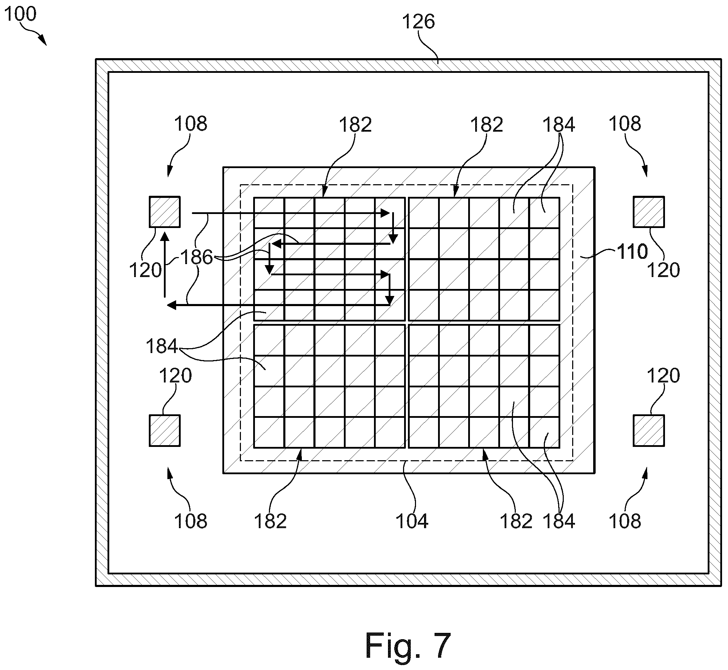

Figure 1 to Figure 6 illustrate different views of an apparatus 100 during execution of a method of filling holes 102 of a component carrier structure 104 with a filling medium 106 according to an exemplary embodiment of the invention. The illustrated holes 102 may be through holes and/or blind holes which may be formed for instance by laser drilling and/or mechanically drilling and which may form electric and/or thermal vias in a readily manufactured component carrier. Additionally or alternatively, the illustrated holes 102 may comprise one or more cavities (for instance for accommodating an embedded component) formed in a core or a stack of a component carrier. The illustrated component carrier structure 104 may be a panel (for instance having a size of 18 inch x 24 inch) or an array (for example a quarter panel) including a plurality of still integrally connected component carriers (such as printed circuit boards or integrated circuit substrates) or preforms thereof. The component carrier structure 104 may also be a single component carrier, such as a printed circuit board, or a single IC substrate. While the embodiment of Figure 1 to Figure 6 shows an apparatus 100 with a single print head 120, embodiments of an apparatus 100 may also comprise a plurality of print heads 120 (see Figure 7 to Figure 9).

Before describing operation of apparatus 100 for filling holes 102 of the component carrier structure 104 according to Figure 1 to Figure 6, an overview of the construction of the apparatus 100 will be given:
Apparatus 100 of Figure 1 to Figure 6 is configured for filling a plurality of holes 102 of a component carrier structure 104 with a filling medium 106. The illustrated holes 102 are through holes extending vertically through the entire panel-type component carrier structure 104. As shown, the component carrier structure 104 is mounted on a support structure 150, such as a jig. The through holes 102 of the component carrier structure 104 are in communication with recesses 152 (such as through holes or cavities, for example formed by depth milling) extending into the support structure 150. The recesses 152 may accommodate excessive filling medium 106 which is not required for filling the holes 102 during a filling process. The recesses 152 may be holes which are defined on the support structure 150, such as a jig. The holes 102 relate to the panel or other kind of component carrier structure 104. They may be of different dimensions, and diameters of the recesses 152 may be larger than diameters of the holes 102. Hence, the dimension of the holes 102 may be different compared to the recesses 152. Additionally or alternatively, the dimension of the holes 102 and of the recesses 152 may be the same.

The support structure 150 is arranged, in turn, on a table 154 with airflow channels 156. Table 154 may contribute to a pressure equilibrium during operation of apparatus 100. The component carrier structure 104 is covered with a perforated screen 110, as described below in further detail.

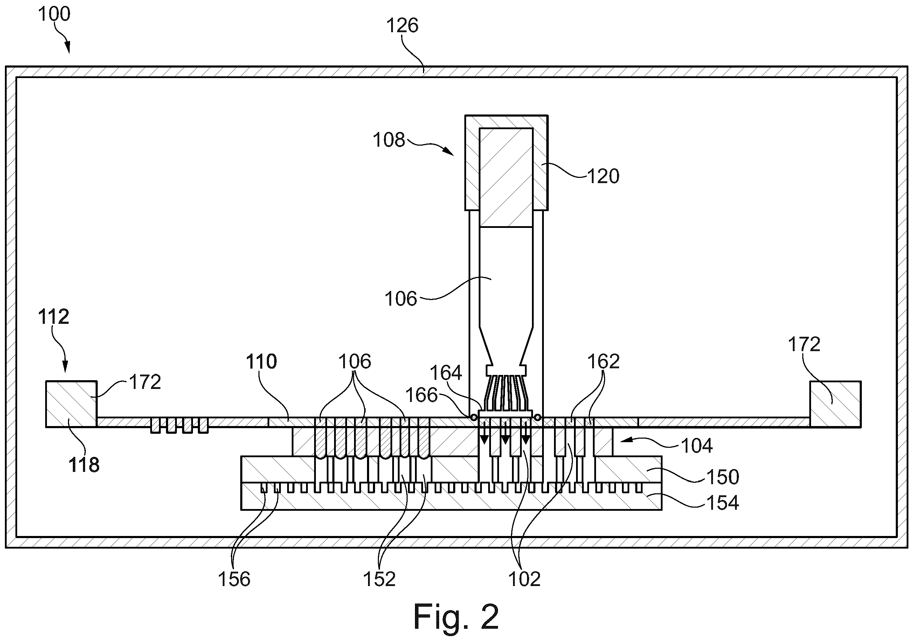

The illustrated apparatus 100 comprises a medium applicator 108 for applying the filling medium 106 into the holes 102 of the component carrier structure 104. Reference sign 102 denotes holes on a working panel to be filled with filling medium 106. A drive mechanism of the medium applicator 108 may move said medium applicator 108 above a main surface of the component carrier structure 104 (compare Figure 1 with Figure 2).

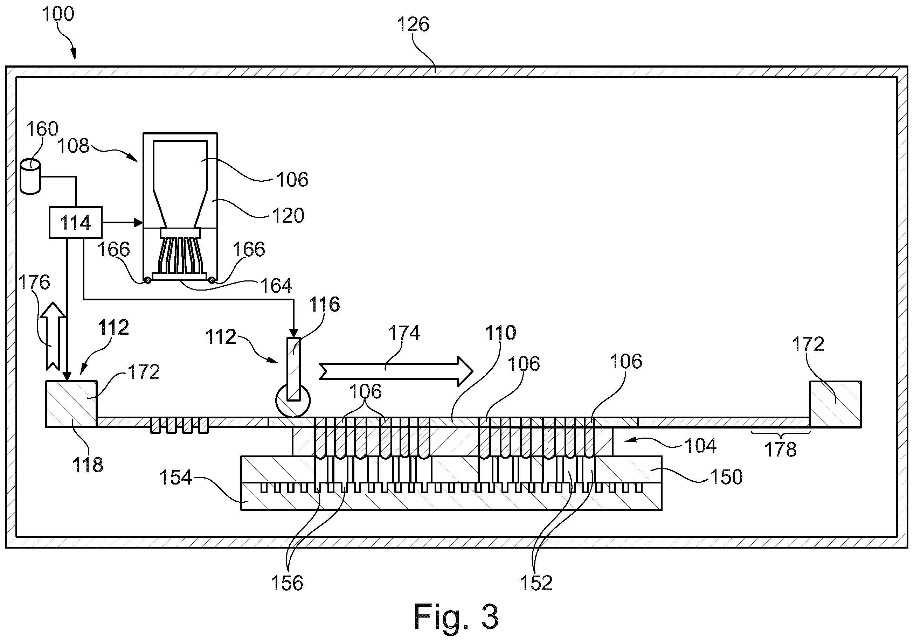

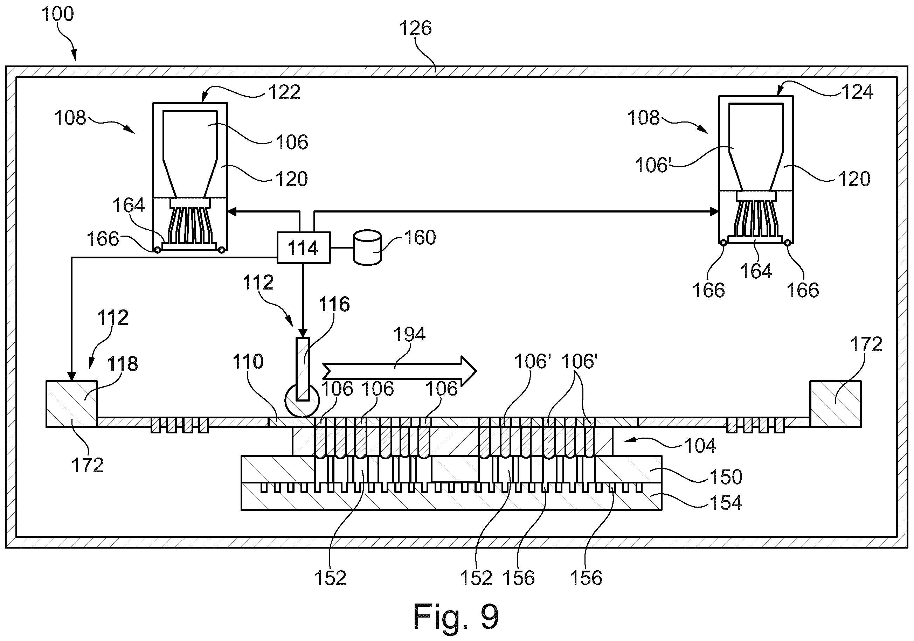

Moreover, apparatus 100 comprises a control unit 114 for controlling the movement of the medium applicator 108. For example, control unit 114 may be a processor coordinating the various constituents of the apparatus 100, for instance in accordance with a control software. Furthermore, the control task executed by the control unit 114 may be adjusted dependent on the properties of the component carriers to be manufactured on the basis of the component carrier structure 104. A corresponding design file may characterize the properties of the component carriers to be manufactured, inter alia position, size and target filling degree of the individual holes 102. Advantageously, the medium applicator 108 may be configured for controlling an amount of filling medium 106 provided for filling a respective hole 102 based on a predefined design (in accordance with the design file) of the component carrier structure 104 and related component carriers. Consequently, an amount of filling medium 106 to be inserted into an individual hole 102 may be different for different holes 102. In order to consider this matter for a hole filling process, Figure 1 shows a database 160 which may store such a design file and such a control software. Control unit 114 may access corresponding data from database 160, which may be embodied as a mass storage device such as a hard drive. Although control unit 114 is shown only in Figure 1 and Figure 3 (and in Figure 9), it may also be present in each and every of the other figures and embodiments. Apart from controlling a hole filling process, control unit 114 may also control a screen detachment process, as described below.

In particular, the control unit 114 may be configured to control motion of the medium applicator 108 so that a medium injector of the medium applicator 108, through which filling medium 106 is injected into the holes 102, is aligned with the respective holes 102 to apply the filling medium 106 into the holes 102. Since the number of holes 102 of the component carrier structure 104 to be filled with filling medium 106 may be larger (in particular much larger) than a group of holes which can be filled by the medium applicator 108 in one injection stage, different groups of holes 102 may be filled group-bygroup by moving the medium applicator 100 between different groups of holes 102, thereby repeating a plurality of times a move-inject-sequence. In each move-inject-cycle, the medium applicator 108 may be spatially aligned with respect to a presently processed group of holes 102 to be presently filled with filling medium 106. For such an alignment, it is possible that alignment marks (not shown, for instance physical marks at screen 110 and/or component carrier structure 104) are detected (in particular optically detected), and a position of the medium applicator 108 is adjusted to achieve alignment with screen 110 and/or component carrier structure 104.

As already mentioned above, the apparatus 100 comprises a perforated screen 110, which may be made for instance of plastic. As indicated by reference sign 170 in Figure 1, the perforated screen 110 may be photo-structured. The perforated screen 110 may be a sheet-like body having a plurality of through holes 162 aligned with the through holes 102 of the component carrier structure 104. The diameter of the holes 102 may be the same as the diameter of the through holes 162. Additionally or alternatively, they may be different. Preferably, the through holes 162 have a bigger diameter than the holes 102 to create an annular ring for alignment tolerances. The difference in the diameter depends on the alignment accuracy of the machine and the filling material properties (such as viscosity).

Hence, the design of the perforated screen 110 may be adjusted to correspond to the design of the component carrier structure 104. During filling the through holes 102 of the component carrier structure 104 with filling medium 106, the perforated screen 110 may be interposed between the medium applicator 108 and the component carrier structure 104. Due to the alignment of the through holes 102 of the component carrier structure 104 with the through holes 162 of the perforated screen 110, filling medium 106 may be injected from the medium applicator 108 through the perforated screen 110 into the presently aligned and processed through holes 102 of the component carrier structure 104. Prior to the filling process, the perforated screen 110 may be placed on the component carrier structure 104 for covering the component carrier structure 104. Said perforated screen 110 is configured to allow the passage of the filling medium 106 through the perforation, i.e. the through holes 162, towards the holes 102 of the component carrier structure 104.

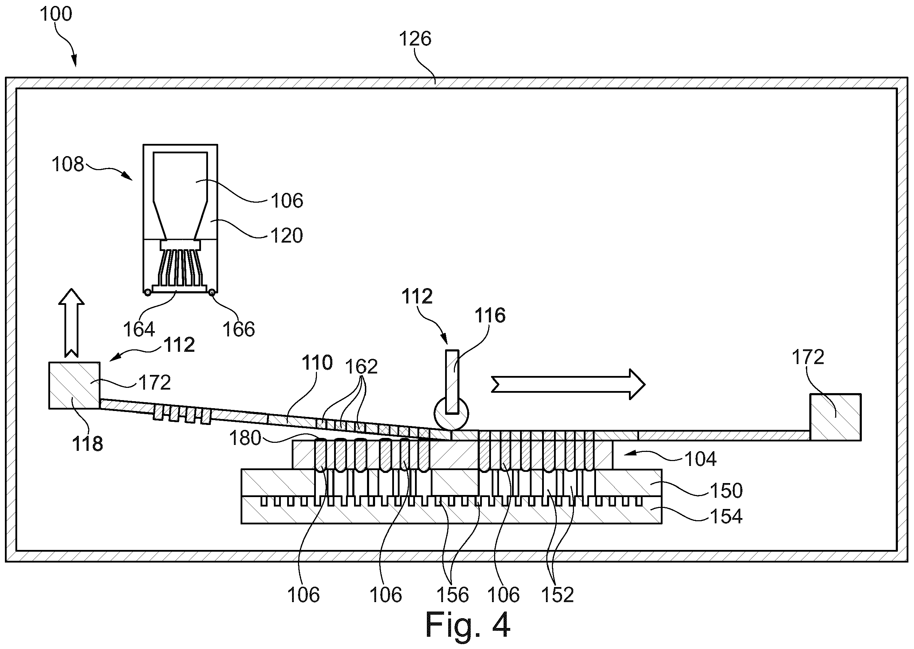

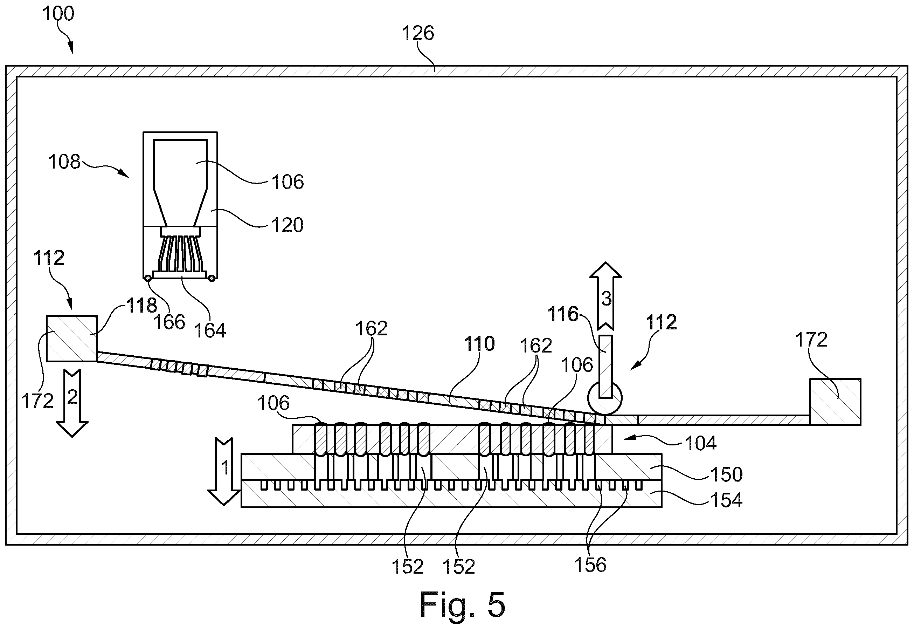

As best seen in Figure 3 to Figure 6, the apparatus 100 comprises a detaching tool 112 for detaching the screen 110 from the component carrier structure 104 after completing the hole filling process. The above-mentioned control unit 114 is configured for controlling the detaching tool 112 to detach the screen 110 from the component carrier structure 104 by pivoting the screen 110 away from the component carrier structure 104 after the filling of the holes 102. Said detaching process will be described below in detail referring to Figure 3 to Figure 6. In the context of said detaching process, the control unit 114 is configured for controlling a first movable part 116 of the detaching tool 112 to move in the horizontal direction along the screen 110, see Figure 3 to Figure 5. Moreover, the control unit 114 is configured for controlling a second movable part 118 of the detaching tool 112 to pivot a portion of the screen 110 connected to the second movable part 118 from the second movable part 118 up to the present position of the first movable part 116 away from the component carrier structure 104. This can be accomplished by an upward motion of the second movable part 118 together with a portion of the perforated screen 110, thereby pivoting and lifting the latter (see Figure 4 and Figure 5).

In the shown embodiment, the first movable part 116 comprises a roller for rolling along the screen 110. Alternatively, the first movable part 116 may comprise a blade made preferably of a low friction material for sliding along the screen 110 (not shown). In contrast to this, the second movable part 118 comprises a supporting structure, such as a frame structure 172, supporting the screen 110 (for example circumferentially). Under control of the control unit 114, the supporting structure the second movable part 118 may move vertically to thereby pivot a connected portion of the screen 110 away from the component carrier structure 104. A present position of the first movable part 116 defines the portion of the screen 110 being pivoted away from the component carrier structure 104, see Figure 4 and Figure 5. Advantageously, the control unit 114 may be configured for controlling the first movable part 116 to move along the screen 110 and for controlling the second movable part 118 to pivot the portion of the screen 110 at least partially simultaneously. By taking this measure, a coordinated operation of the movable parts 116, 118 may be ensured.

Again referring to Figure 1, the medium applicator 108 may be provided with a print head 120 for printing the filling medium 106 in the holes 102 of the component carrier structure 104. This printing process may be an injection printing process. Also a plurality of print heads 120 may be foreseen, see Figure 7 to Figure 9. In Figure 1 to Figure 6, only a single print head 120 is shown, wherein a plurality of print heads 120 may be present in this embodiment as well. Under control of control unit 114 and a motion mechanism, the print head 120 can be moved along the component carrier structure 104 for sequentially printing the filling medium 106 into groups of the holes 102 of the component carrier structure 104. The print head 120 may be filled with an appropriate filling medium 106 (for instance from a reservoir). The print head 120 may be filled with a pre-defined amount of filling medium 106. The filling medium 106 may be accommodated inside of a cartridge 168 of the medium applicator 108. For example, the filling medium 106 comprises dielectric ink (when a filling of the through holes 102 with a dielectric material is intended), a magnetic paste (when a filling of the through holes 102 shall fulfill a magnetic shielding function or a magnetic application function), or a metallic paste (for instance a solder paste or a sinter paste). Upon application, the filling medium 106 may be liquid or viscous.

Advantageously, the medium applicator 108 is configured for a volume-based control of an amount of filling medium 106 provided for filling a respective hole 102. In other words, the medium applicator 108 may be controlled by the control unit 114 for injecting filling medium 106 into a respective hole 102 so that a predefined metered volume of filling medium 106 is injected. By such a volume-based control, a precise filling of the holes 102 may be ensured independently of the viscosity of the filling medium 106. Hence, a volume based dosing system is advantageously provided which may dose or meter independently of a viscosity.

As best seen in Figure 1 and Figure 2, the medium applicator 108 may be configured to fill a group of the holes 102 of the component carrier structure 104 simultaneously. For this purpose, an injection interface 164 of the print head 120 may be spatially widened so as to cover a group of holes 102 during the filling process for filling all said holes 102 of the group at the same time. For avoiding a flow of a flowable filling medium 106 to an unintended destination, a circumferential sealing 166 may surround the injection interface 164 for sealing between print head 120 and perforated screen 110.

Some or all of the mentioned constituents of the apparatus 100 may be placed inside of a vacuum chamber 126 for executing the medium filling process in a vacuum. In particular, the medium applicator 108, the detaching tool 112, the perforated screen 110 and the component carrier structure 104 are arranged inside of the vacuum chamber 126 during the filling process. This may ensure that no or substantially no air is inside the holes 102, which may render the filling process highly reproducible.

The apparatus 100 according to Figure 1 may also comprise an alignment system for aligning the perforated screen 110 with respect to the component carrier structure 104 for ensuring a high spatial precision of the process of inserting filling medium 106 in the holes 102 of the component carrier structure 104.

Next, execution of a method of filling the holes 102 of the component carrier structure 104 with filling medium 106 using the above described injection-based apparatus 100 which will be explained:
As shown in **Figure 1****,** the injection print head 120 is moved down to a zero position. When being placed at the zero position, an outflow of filling medium 106 out of the medium applicator 108 may be enabled.

Referring to **Figure 2****,** the medium applicator 108 is moved along the perforated screen 110 for subsequently filling groups of holes 102 with filling medium 106 by injecting filling medium 106 in a volume-controlled fashion through the perforated screen 110 into the holes 102 of the component carrier structure 104. Thus, in terms of applying the filling medium 106 into the holes 102 of the component carrier structure 104, medium applicator 108 is moved under control of control unit 114 above and along main surfaces of the component carrier structure 104 and of the perforated screen 110. The control unit 114 controls the movement of the medium applicator 108 to align with the holes 102 of a presently processed group to apply the filling medium 106 into the holes 102. Since the component carrier structure 104 is covered with the perforated screen 110, the filling medium 106 can be applied by the medium applicator 108 through the perforated screen 110 into the holes 102 of the component carrier structure 104 in a highly accurate way. During this process, a dosing system or metering unit of the medium applicator 108 may dose or meter a predefined volume of filling medium 106 into each assigned hole 102. When a group of holes 102 is filled with filling medium 106 simultaneously, the predefined volume of filling medium 106 may correspond to the sum of the individual volumes of said holes 102 of the group. For subsequently filling all groups of holes 102, the motion mechanism may slide the medium applicator 108 from injection position to injection position. When aligned at a certain injection position, the medium applicator 108 may be stopped during the filling process to ensure alignment.

Hence, the print head 120 slides, during the filling process from the first to the next and finally to the last group of holes 102. During injecting filling medium 106 into holes 102, the print head 120 may apply an appropriate pressure to the perforated screen 110 to achieve a proper sealing. For instance, said pressure may be selected in a range from 10 mbar to 10 bar, in particular from 100 mbar to 1 bar. During injection, the print head 120 injects a pre-defined amount of ink into the holes 102. These processes may be repeated until all holes 102 are filled with filling medium 106.

After completing the filling process, the perforated screen 110 may be detached from the component carrier structure 104 in a detaching process starting in **Figure 3****.** As shown, the first movable part 116 of the detaching tool 112 is controlled by control unit 114 to move along the screen 110 with direct physical contact along a horizontal direction 174. Simultaneously, the second movable part 118 can be controlled by the control unit 114 to move along a peel-off motion direction, which a vertical direction 176 according to Figure 3. Since the second movable part 118 forms part of a frame structure 172 which circumferentially holds the perforated screen 110, moving the second movable part 118 upwardly will cause a pivoting of a portion of the perforated screen 110 between the second movable part 118 and the first movable part 116 (see Figure 4 and Figure 5). This will subsequently peel off the perforated screen 110 section-by-section from the component carrier structure 104 without the risk of damage.

Thus, Figure 3 shows the beginning of a screen separation process. For this purpose, the print head 120 slides to its zero position and gets lifted up. The roller-type first movable part 116 travels from its off-duty point to a starting point. Thereafter, the roller-type first movable part 116 starts rolling on the perforated screen 110. Consequently, the perforated screen 110 starts a peel-off motion since a part of the frame structure 172 corresponding to the second movable part 118 is lifting up. A possible end position of the first movable part 116 is indicated in Figure 3 by reference sign 178.

**Figure 4** shows how the screen 110 is detached more and more from the component carrier structure 104 by controlling the detaching tool 112 to pivot the screen 110 away from the component carrier structure 104. This can be achieved by controlling the second movable part 118 of the detaching tool 112 to pivot a portion of the screen 110 up to the first movable part 116 away from the component carrier structure 104. The first movable part 116 may thus help to separate the perforated screen 110 from the component carrier structure 104 in a smooth way and without causing artefacts from the filling medium 106.

Hence, Figure 4 illustrates continued screen separation while the roller-type first movable part 116 is travelling on the screen 110. A portion of the screen 110 between the first movable part 116 and the second movable part 118 is lifting up. By embodying the first movable part 116 with a roller, it may be ensured that the first movable part 116 moves with low friction along the perforated screen 110 without damaging the latter, in particular without damaging its photo-structuring.

As indicated by reference sign 180, a slight overfilling of the holes 102 with filling medium 106 may occur. This may serve as a confirmation that the holes 102 are in fact completely filled with filling medium 106.

Referring to **Figure 5****,** screen separation has continued and is now almost completed. When the roller-type first movable part 116 stops at its final or end position, the peel-off motion may stop. As indicated by an arrow 1, the table 154 may move downwards, so that the panel-type component carrier structure 104 may get completely separated from the perforated screen 110. As indicated by an arrow 2, the second movable part 118 of the frame structure 172 moves downwardly to its original position. As indicated by an arrow 3, the roller-type first movable part 116 may get lifted up.

Advantageously, the first movable part 116 ensures that the screen 110 does not get stuck on the component carrier structure 104, so that the filling medium 106 can be prevented from leaving the holes 102 of the component carrier structure 104 unintentionally.

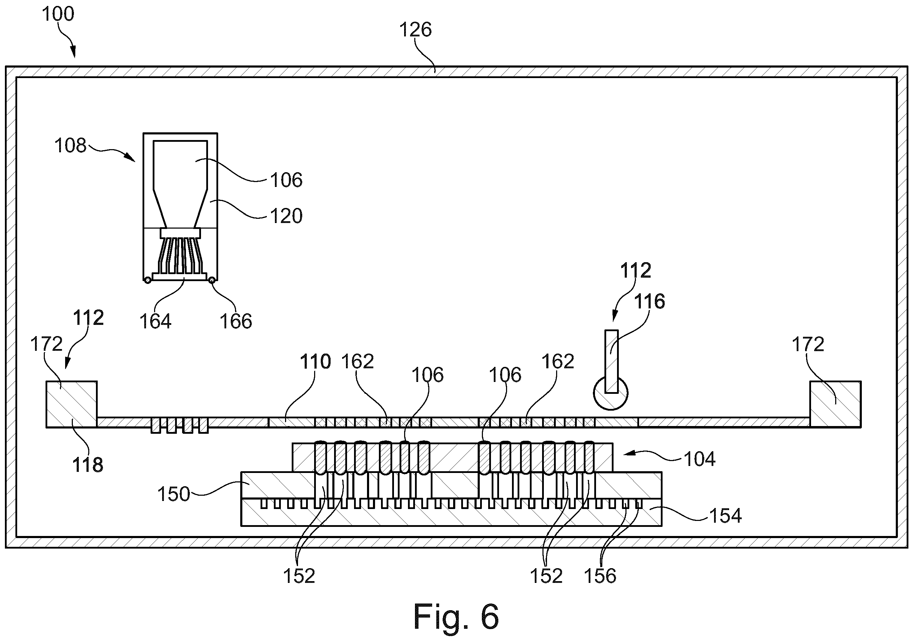

As shown in **Figure 6****,** the printing cycle can then be finished. The roller-type first movable part 116 may travel to its off-duty position, and the table 154 may travel out.

Figure 7 to Figure 9 illustrate different views of an apparatus 100 during execution of a method of filling holes 102 of a component carrier structure 104 with a filling medium 106 according to another exemplary embodiment of the invention.

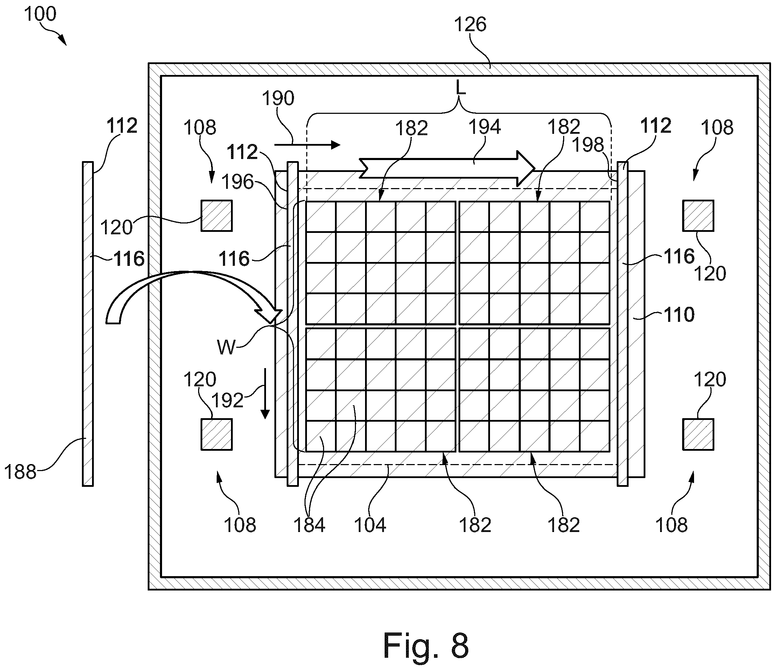

In such an embodiment, the medium applicator 108 comprises a plurality of print heads 120 each for printing the filling medium 106 in the holes 102 of an assigned portion of the component carrier structure 104. Figure 7 and Figure 8 show an example of four print heads 120, each operating on a respective quarter panel 182 of the panel-type component carrier structure 104. As shown as well, each quarter panel 182 may comprise a plurality of preforms of component carriers 184, for example printed circuit boards. During injecting filling medium 106 into holes 102 of the component carrier structure 104, each print head 120 may move along a defined movement route or trajectory 186. In the shown embodiment, the trajectory 186 may include a meandric path along the preforms of component carriers 184. Motion of the print heads 120 along respective trajectories 186 may be controlled by control unit 114. To put it shortly, Figure 7 and Figure 8 show a design relating to a full panel concept with four print heads 120.

Referring to **Figure 7****,** hole filling with an injection apparatus 100 is shown in a top view.

During operation of the apparatus 100 of Figure 7, the injection print heads 120 may go down to a zero position. Each of the print heads 120 may be filled with a pre-defined amount of ink-type filling medium 106. Each of the print heads 120 may slide to its first, next, ..., last injection position. Each of the print heads 120 may apply a pressure on perforated screen 110 to achieve a proper sealing. A pre-defined amount of filling medium 106 may then be injected by each respective print head 120. These processes may be repeated until all holes 102 are filled with filling medium 106. Thereafter, the print heads 120 may slide to a zero position and get lifted up.

Referring to **Figure 8****,** operation of the first movable part 116 during a screen separation process is illustrated. On the left side of Figure 8, the first movable part 116 is shown at its off duty point 188. A roller peel-off starting point is shown with reference sign 196. A final position of the roller is indicated with reference sign 198. As shown in Figure 8, the first movable part 116 extends along an entire width W of the component carrier structure 104. A width direction corresponding to the width W of the component carrier structure 104 is indicated with reference sign 192 and extends perpendicular to a length direction 190 of the component carrier structure 104 corresponding to the length L of the component carrier structure 104. The control unit 114 may be configured for controlling the first movable part 116 to move (see movement direction 194) along the screen 110 along the entire length L of the component carrier structure 104.

During operation, the roller-type first movable part 116 travels from the off-duty point to starting point. Thereafter, the roller starts rolling on the screen 110, which starts its peel-off motion. When the roller stops at the final position 198, the peel-off motion stops. The table 154 moves downwards, and the panel-type component carrier structure 104 gets completely separated from the screen 110. The frame structure 172 moves down to the original position. The roller gets lifted up and travels to the off-duty position, and the table 154 travels out. Then, the printing cycle is finished.

**Figure 9** shows that the medium applicator 108 can comprise a plurality of print heads 120 or other kinds of applicator units. According to Figure 9, a first applicator unit 122 is provided for applying a first filling medium 106 into a first part of the holes 102 of the component carrier structure 104. Furthermore, a second applicator unit 124 is provided for applying another second filling medium 106' into a second part of the holes 102 of the component carrier structure 104. For instance, the first filling medium 106 may be a dielectric ink, whereas the second filling medium 106' may be a magnetic ink. Thus, different holes 102 of the component carrier structure 104 may be filled with different filling media 106, 106', which may be defined for each hole 102 in a design file accessible by the control unit 114. The control unit 114 may control the printing process in accordance with the design file.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. An apparatus (100) for filling holes (102) of a component carrier structure (104) with a filling medium (106), wherein the apparatus (100) comprises:
a medium applicator (108) for applying the filling medium (106) into the holes (102) of the component carrier structure (104), said medium applicator (108) being configured to move above a main surface of the component carrier structure (104); and
a control unit (114) for controlling the movement of the medium applicator (108) to align with the holes (102) to apply the filling medium (106) into the holes (102).

2. The apparatus (100) according to claim 1, further comprising a perforated screen (110) at least partially covering the component carrier structure (104), said perforated screen (110) being configured to allow the passage of the filling medium (106) through the perforation toward the holes (102) of the component carrier structure (104).

3. The apparatus (100) according to claim 2, further comprising:
a detaching tool (112) for detaching the screen (110) from the component carrier structure (104);
wherein the control unit (114) is configured for controlling the detaching tool (112) to detach, in particular by pivoting, the screen (110) away from the component carrier structure (104), in particular after the filling of the holes (102).

4. The apparatus (100) according to claim 3, wherein the control unit (114) is configured for controlling a first movable part (116) of the detaching tool (112) to move along the screen (110) and for controlling a second movable part (118) of the detaching tool (112) to pivot a portion of the screen (110) up to the first movable part (116) away from the component carrier structure (104).

5. The apparatus (100) according to claim 4, wherein the first movable part (116) comprises a roller for rolling along the screen (110).

6. The apparatus (100) according to any of claims 4 to 5, wherein the second movable part (118) comprises a supporting structure, in particular a frame structure (172), supporting the screen (110), wherein in particular the control unit (114) is configured to move the supporting structure to thereby pivot said portion of the screen (110) away from the component carrier structure (104).

7. The apparatus (100) according to any of claims 4 to 6, wherein the first movable part (116) extends along an entire width (W) of the component carrier structure (104).

8. The apparatus (100) according to any of claims 1 to 7, wherein the medium applicator (108) comprises at least one print head (120) for printing the filling medium (106) in the holes (102) of the component carrier structure (104), wherein in particular the at least one print head (120) is configured for moving along the component carrier structure (104) for printing the filling medium (106) in the holes (102) of the component carrier structure (104).

9. The apparatus (100) according to any of claims 1 to 8, wherein the medium applicator (108) comprises a plurality of print heads (120) each for printing the filling medium (106) in the holes (102) of an assigned portion, in particular a quarter panel, of the component carrier structure (104).

10. The apparatus (100) according to any of claims 1 to 9, wherein the medium applicator (108) comprises a first applicator unit (122) for applying a first filling medium (106) into a first part of the holes (102) of the component carrier structure (104) and comprises a second applicator unit (124) for applying another second filling medium (106') into a second part of the holes (102) of the component carrier structure (104).

11. The apparatus (100) according to any of claims 1 to 10, wherein the medium applicator (108) is configured for controlling an amount of filling medium (106) provided for filling a respective hole (102) based on a predefined design of the component carrier structure (104).

12. The apparatus (100) according to any of claims 1 to 11, wherein the medium applicator (108) is configured for a volume-based control of an amount of filling medium (106) provided for filling a respective hole (102).

13. A method of filling holes (102) of a component carrier structure (104) with a filling medium (106), wherein the method comprises:
applying the filling medium (106) into the holes (102) of the component carrier structure (104) by a medium applicator (108) moving above a main surface of the component carrier structure (104); and
controlling the movement of the medium applicator (108) to align with the holes (102) to apply the filling medium (106) into the holes (102).

14. The method according to claim 13, wherein the method comprises:
covering the component carrier structure (104) with a perforated screen (110) ;
applying the filling medium (106) by the medium applicator (108) through the perforated screen (110) into the holes (102) of the component carrier structure (104); and
detaching the screen (110) from the component carrier structure (104) by controlling a detaching tool (112) to pivot the screen (110) away from the component carrier structure (104).

15. The method according to claim 14, wherein the method comprises:
controlling a first movable part (116) of the detaching tool (112) to move along the screen (110); and
controlling a second movable part (118) of the detaching tool (112) to pivot a portion of the screen (110) up to the first movable part (116) away from the component carrier structure (104).
